# EUROPÄISCHE PATENTSCHRIFT

(11) **EP 1 620 578 B1**
(45) Veröffentlichungstag und Bekanntmachung des Hinweises auf die Patenterteilung: **21.05.2014**
(21) Anmeldenummer: 04729035.8
(22) Anmeldetag: 23.04.2004
(51) Int. Cl.: C23C 16/30, C23C 30/00

(54) **WERKZEUG UND VERFAHREN ZUR CVD-ABSCHEIDUNG EINER ZWEIPHASIGEN SCHICHT AUF EINEM SUBSTRATKÖRPER**
TOOL AND METHOD FOR THE CHEMICAL VAPOR DEPOSITION OF A TWO-PHASE LAYER ON A SUBSTRATE MEMBER
OUTIL ET PROCEDE POUR REALISER UN DEPOT CHIMIQUE EN PHASE VAPEUR D'UNE COUCHE A DEUX PHASES SUR UN SUBSTRAT

(30) Priorität: 07.05.2003 DE 10320652; 02.03.2004 DE 102004010594
(43) Veröffentlichungstag der Anmeldung: 01.02.2006
(73) Patentinhaber: Kennametal Widia Produktions GmbH & Co. KG, 45145 Essen (DE)
(72) Erfinder: SOTTKE, Volkmar, 45479 Mülheim/Ruhr (DE); WESTPHAL, Hartmut, 36466 Dermbach/Rhön (DE); VAN DEN BERG, Hendrikus, NL-5925 BT Venlo-Blerick (NL)
(74) Vertreter: Vomberg, Friedhelm
(86) Internationale Anmeldenummer: PCT/DE2004/000845
(87) Internationale Veröffentlichungsnummer: WO 2004/099463

(56) Entgegenhaltungen:
- WO-A-00/17416
- US-A- 4 714 660
- US-B1- 6 426 137
- PATENT ABSTRACTS OF JAPAN Bd. 2003, Nr. 05, 12. Mai 2003 (2003-05-12) -& JP 2003 001502 A (MMC KOBELCO TOOL KK), 8. Januar 2003 (2003-01-08) -& DATABASE WPI Section Ch, Week 200317 Derwent Publications Ltd., London, GB; Class L02, AN 2003-171153 XP002301273
- PATENT ABSTRACTS OF JAPAN Bd. 2002, Nr. 12, 12. Dezember 2002 (2002-12-12) -& JP 2002 224903 A (HITACHI TOOL ENGINEERING LTD), 13. August 2002 (2002-08-13)

## Beschreibung

Die Erfindung betrifft ein Werkzeug, insbesondere ein Schneidwerkzeug, bestehend aus einem Substratkörper, auf dem mindestens eine zweiphasige Schicht mittels CVD abgeschieden ist. Ferner betrifft die Erfindung ein Verfahren zur CVD-Abscheidung einer zweiphasigen Schicht auf einem Substratkörper.

Beschichtete Substratkörper zur Verwendung als Schneidelemente sind grundsätzlich bekannt.

So werden beispielsweise in der DE 100 17 909 A1 Substratkörper auf Wolframcarbidbasis und einer harten Beschichtung erwähnt, die eine Titanverbundschicht mit wenigstens einer Schicht aus TiC, TiN, TiCN, TiCO und TiCNO und eine Al₂O₃ und/oder Al₂O₃-ZrO₂-Verbundschicht aufweist. Im letztgenannten Fall sind ZrO₂-Teilchen in eine Al₂O₃-Phase dispergiert. Bekannt sind darüber hinaus auch Schichtfolgen TiN-TiCN-TiN-Schichten, ggf. mit einer zusätzlichen äußeren Al₂O₃-Schicht. Al₂O₃-Schichten, die mittels eines CVD-Verfahrens abgeschieden werden, können je nach Verfahrensbedingungen in Form von α-, κ- oder amorphem Al₂O₃ auftreten. Die DE 100 17 909 A1 erwähnt zur Herstellung einer TiCN-Schicht ein CVD-Verfahren, bei dem in einem mittleren Temperaturbereich zwischen 700 °C und 950 °C unter Verwendung eines Reaktionsgasgemisches gearbeitet wird, das CH₃CN beinhaltet.

JP 2002-224903 offenbart ein Schneidwerkzeug aus einem beschichteten Hartmetall, auf dem eine (Ti,Zr)(C,N,O) Beschichtung eingelagert ist. Diese Beschichtung wird durch einem CVD-Verfahren unter Verwendung TiCl4, ZrCl4, CH3CN, CO2, H2 und N2 hergestellt.

Schließlich offenbart die WO 00/47416 A1 einen Verbundwerkstoff aus einem beschichteten Hartmetall- oder Cermetgrundkörper, auf dem die einzige oder bei einer mehrlagigen Beschichtung mindestens eine 0,5 µm bis 25 µm dicke Schicht, vorzugsweise die äußerste, eine Al₂O₃- und eine Phase enthält, die aus ZrO₂ und/oder HfO₂ besteht und in der zusätzlich eine dritte feindispersive Phase, beste-hend aus einem Oxid, Oxicarbid, Oxinitrid oder Oxicarbonitrd des Titans, eingelagert ist.

Es ist Aufgabe der vorliegenden Erfindung, ein verbessertes Werkzeug, insbesondere ein Schneidwerkzeug der eingangs genannten Art anzugeben, das aufgrund seiner Beschichtung sowohl bei trockenen als auch bei nassen Zerspanungen, insbesondere beim Drehen von Gusswerkstoffen oder Vergütungsstählen (CK45), verbesserte Standzeiten aufweist.

Diese Aufgabe wird durch das Werkzeug nach Anspruch 1 gelöst, das erfindungsgemäß dadurch gekennzeichnet ist, dass die einzige abgeschiedene zweiphasige Schicht oder mindestens eine der zweiphasigen Schichten neben einer TiCN- oder einer TiOCN- oder einer TiC- oder einer TiOC-Phase eine weitere Phase, bestehend aus ZrO₂ oder HfO₂ aufweist. Diese mehrphasige Schicht kann die einzige Schicht, eine Zwischenschicht oder eine äußere Schicht sein, wobei je nach Anwendungsfall der Anteil der genannten variiert werden kann, wobei zu berücksichtigen ist, dass mit steigendem ZrO₂- oder HfO₂-Anteil die Härte der betreffenden Schicht abnimmt.

Weiterbildungen des Werkzeuges sind in den Unteransprüchen beschrieben.

So kann die genannte weitere Phase aus ZrO₂ oder HfO₂ in monokliner und/oder tetragonaler Form vorliegen.

Auf der nach Anspruch 1 definierten Schicht kann nach einer weiteren Ausgestaltung auch eine Al₂O₃-Schicht, vorzugsweise als äußere Schicht und weiterhin vorzugsweise als α- Al₂O₃-Schicht abgeschieden sein. Der Substratkörper kann aus einem Hartmetall, einem Cermet oder einer Keramik bestehen.

Bevorzugt liegt das Verhältnis der TiCN-, TiOCN-, TiC oder TiOC-Phase zur weiteren Phase aus ZrO₂ und/oder HfO₂ zwischen 4 : 1 und 1 : 4, vorzugsweise zwischen 2 . 1 und 1 : 2.

Wie bereits erwähnt, kann beispielsweise die erste Phase aus TiCN oder TiOCN auch durch TiC oder TiOC ersetzt sein, d.h., dass das Verhältnis C : N von 0,5 0,5 auf 1,0 : 0 gesetzt werden kann.

Die vorliegende Erfindung umfasst auch solche Werkzeuge, bei denen in der TiCN- oder TiOCN- oder TiOC- oder TiC-Phase das Titan zu einem geringeren Anteil durch Zr und/oder Hf ersetzt ist. Allerdings wird in der Verbindung TiCₓNyO_{z} mit 0 ≤x, y, z ≤1 deutlich weniger als die Hälfte des Titans durch Zr oder Hf ersetzt, vorzugsweise maximal 20% bzw. weiterhin vorzugsweise maximal 10% des Titans. Solche Verbindungen entstehen beispielsweise dann, wenn die Gasatmosphäre, aus der die betreffenden Phasen abgeschieden werden, einen unterstöchiometrischen Sauerstoffgehalt aufweist.

Nach einer weiteren Ausgestaltungsvariante der Erfindung ist die zweiphasige Schicht eine Zwischenlage, die zwischen zwei TiN-Schichten oder als Zwischenlage zwischen TiCN und Al₂O₃ bzw. angeordnet ist, worauf außen eine ZrCN-Schicht abgeschieden ist.

Zur Herstellung des erfindungsgemäßen Werkzeuges wird vorgeschlagen, dass auf den gesinterten Substratkörper zur CVD-Abscheidung der vorgenannten mehrphasigen Schicht nach dem Verfahren gemäß Anspruch 8 gearbeitet wird, das dadurch gekennzeichnet ist, dass in der Gasatmosphäre neben TiCl₄, HfCl₄ oder ZrCl₄ und CO₂ zusätzlich CH₃CN (Acetonitril) oder C₅H₅N (Pyridin) oder C₆H₆ (Benzen), Rest H₂ und/oder Ar verwendet werden. Im Falle der Verwendung von Acetonitril laufen in der Gasphase folgende simultanen Reaktionen ab:

2 TiCl₄ + CH₃CN + 4,5 H₂ → 2 TiC_{0,5}N_{0,5} + CH₄ + 8 HCl

ZrCl₄ + 2 CO₂ + 2 H₂ → ZrO₂ + 2 CO + 4 HCl

oder

2 TiCl₄ + CH₃CN + 4,5 H₂ → 2 TiC_{0,5}N_{0,5} + CH₄ + 8 HCl

HfCl₄ + 2 CO₂ + 2 H₂ → HfO₂ + 2 CO + 4 HCl

Entsprechende Reaktionen ergeben sich, wenn statt Aceton Pyridin verwendet wird, bei dem als Reaktionsprodukt ebenfalls eine TiCₓN_{y}-Phase entsteht. Allerdings ändert sich bei der Verwendung von Pyridin in der Gasphase das C : N-Verhältnis von 0,5 : 0,5 zu 0,7 : 0,3 und für Benzen zu 1,0 : 0, d.h., dass in der ersten Phase weniger bzw. kein Stickstoff enthalten ist.

Bevorzugt werden folgende Gasanteile verwendet:
TiCl₄ : 1 bis 4 Vol%, vorzugsweise 1 bis 2 Vol%
ZrCl₄ oder HfCl₄ : 0,3 bis 4 Vol%, vorzugsweise 0,5 bis 2 Vol%
C₅H₅N oder CH₃CN oder C₆H₆: 0,2 bis 2 Vol%, vorzugsweise 0,5 bis 1 Vol%
CO₂ : 0,1 bis 3 Vol%, vorzugsweise 0,3 bis 2 Vol%, Rest Ar und/oder H₂.

Die Abscheidetemperaturen liegen nach einer bevorzugten Anwendung der Erfindung zwischen 800 °C und 1000 °C, der Gasatmosphärendruck beträgt 5 x 10³ Pa bis 6 x 10⁴ Pa.

In einem konkreten Ausführungsbeispiel sind auf einem Hartmetallsubstratkörper mit einer Hartstoffphase aus WC und einer Binderphase von 6 Massen% Co Schichtfolgen TiN-TiCN/HfO₂-TiN abgeschieden worden, wobei zur Abscheidung der vorgenannten mittleren Schicht folgende Gasphasenzusammensetzung gewählt worden ist:
1,4 Vol% TiCl₄, 1,4 Vol% HfCl₄, 0,8 Vol% CH₃CN, 0,5 Vol% CO₂, Rest H₂.

Die jeweiligen TiN-Lagen sind unter Verwendung eines konventionellen CVD-Beschichtungsverfahrens hergestellt worden.

In entsprechender Weise sind auf dem Hartmetall-Substratkörper auch Schichtfolgen TiN-TiCN-TiCN/HfO₂-α-Al₂O₃ abgeschieden worden, wobei überraschenderweise festgestellt worden ist, dass sich auf der erfindungsgemäßen mehrphasigen Zwischenlage TiCN/HfO₂ mittels eines CVD-Verfahrens das stabile α-Al₂O₃ generieren lässt.

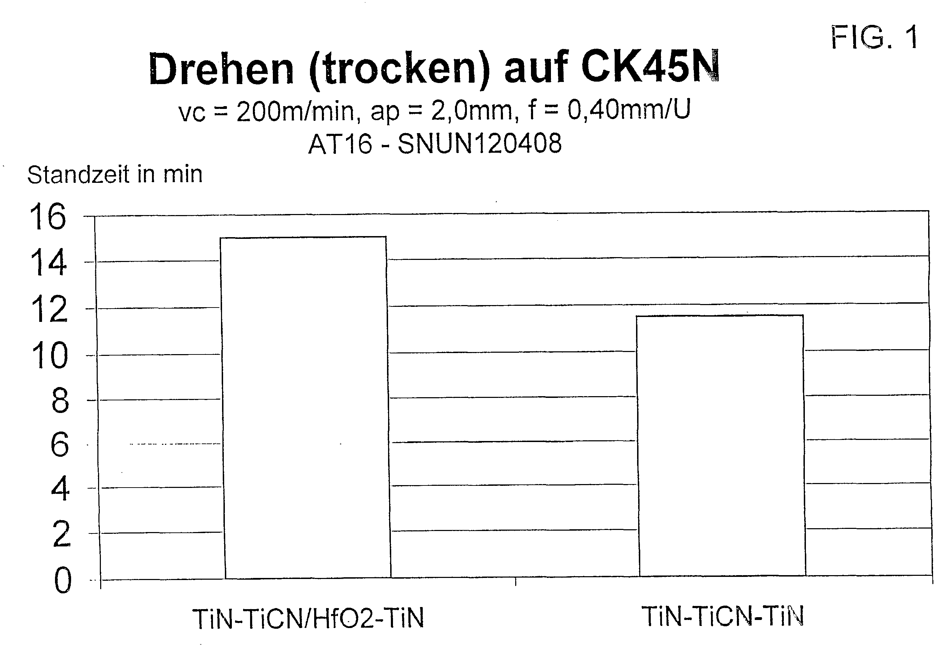

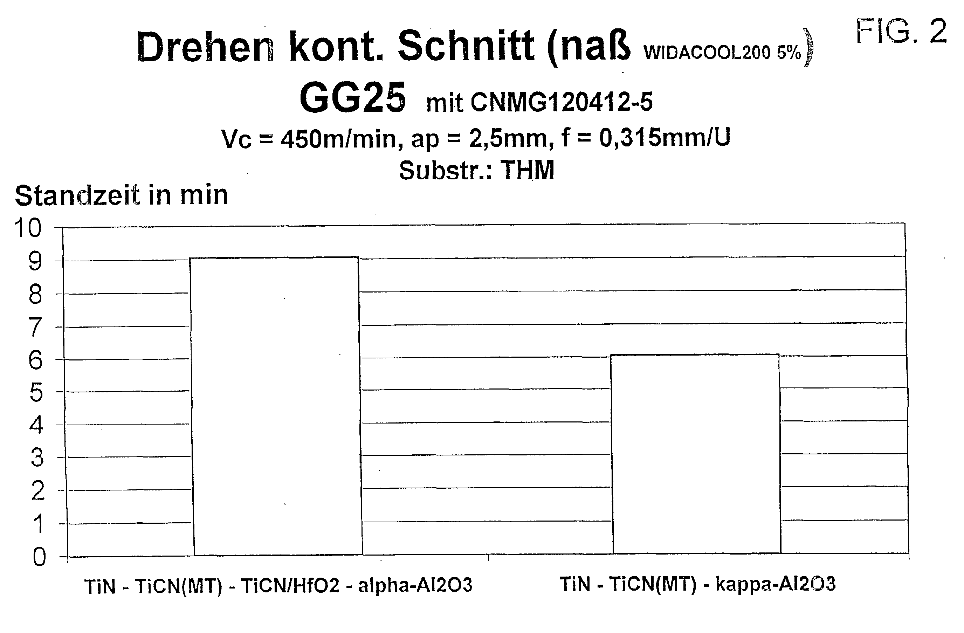

Die Vorteile der Erfindung, die nachstehend erläutert werden, ergeben sich aus den Zeichnungen. Es zeigen
- Fig. 1 bis 3: jeweils gemessene Standzeiten in einer Balkendiagrammgegenüberstellung.

Wie vorstehend beschrieben, ist auf einem Hartmetallsubstratkörper, der die Form einer Schneidplatte des Typs SNUN120408 besitzt, im ersten Fall eine erfindungsgemäße Schichtfolge TiN-TiCN/HfO₂-TiN aufgetragen worden. Die mittlere Schicht besitzt somit zwei Phasen, nämlich TiCN einerseits und HfO₂ andererseits.

Im Vergleich dazu ist ein Substratkörper derselben Zusammensetzung und desselben Typs mit einer dreilagigen Beschichtung TiN-TiCN-TiN versehen worden. Beim Drehen im trockenen Schnitt einer Stahlsorte CK45N mit den Parametern v_{c} = 200 m/min, aₚ = 2,0 mm und f = 0,4 mm/U konnten mit der erfindungsgemäßen Beschichtung Standzeiten von ca. 15 min erreicht werden, wohingegen die Standzeit des Vergleichskörpers nach dem Stand der Technik weniger als 12 min betrug.

Auch bei einem Vergleich von Schneidkörpern mit einer nach dem Stand der Technik bekannten Beschichtung der Schichtfolge TiN-TiCN-κ- Al₂O₃ mit einer erfindungsgemäßen Beschichtung TiN-TiCN-TiCN/HfO₂-α- Al₂O₃ konnten beim Drehen im kontinuierlichen Schnitt unter Verwendung eines Kühl-Schmiermittels, d.h. im nassen Schnitt, deutliche Standzeitenverbesserungen erreicht werden. Während bei der nach dem Stand der Technik bekannten Schichtfolge, bei der die mittlere TiCN-Schicht bei Abscheidetemperaturen zwischen 800 °C und 1000 °C aufgetragen worden ist und worauf aus der Gasphase κ-Al₂O₃ abgeschieden wurde, lediglich Standzeiten von 6 min erreichbar waren, steigerte sich die Standzeit bei solchen Schichtfolgen, in denen zwischen der TiCN-Schicht und der Al₂O₃-Schicht eine zweiphasige Zwischenschicht aus TiCN und HfO₂ eingefügt wurde. Diese Zwischenschicht erlaubte auch unter denselben Verfahrensbedingungen die Abscheidung von α-Al₂O₃. Die erhaltene Standzeit von 9 min stellt eine 50 %ige Verbesserung dar. In den Vergleichsversuchen bestand das Werkstück aus einem Gusskörper der Sorte GG25, der mit einem Schneidkörper des Typs CNMG120412-5 bearbeitet wurde. Die verwendeten Dreh-Parameter waren:
v_{c} = 450 m/min, aₚ = 2,5 mm und f = 0,315 mm/U.

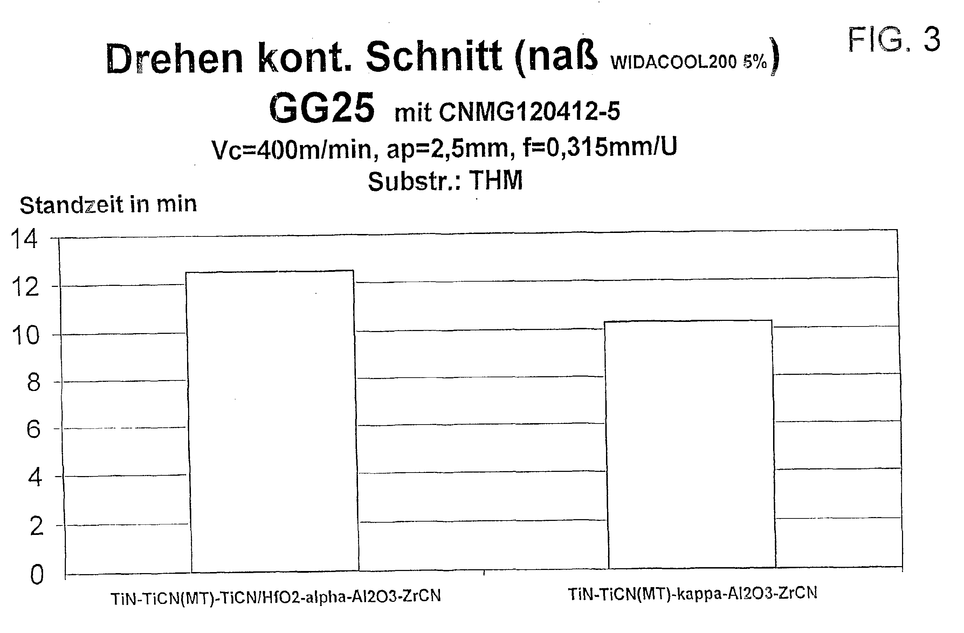

Wie aus Fig. 3 ersichtlich, konnte die erfindungsgemäße Beschichtung auch beim Nassdrehen im kontinuierlichen Schnitt eine erhebliche Standzeitverbesserung liefern. Auf einen Substratkörper derselben Zusammensetzung des Typs CNMG120412-5 ist eine erfindungsgemäße Schichtfolge der Zusammensetzung TiN-TiCN (MT)-TiCN/HfO₂-α-Al₂O₃-ZrCN im ersten Fall und im zweiten Fall der Zusammensetzung TiN-TiCN(MT)-κ-Al₂O₃-ZrCN aufgetragen worden. Beide Schneideinsätze sind zur Drehbearbeitung eines Gusskörpers der Sorte GG25 bearbeitet worden, wobei folgende Verfahrensparameter verwendet wurden:
v_{c} = 400 m/min, aₚ = 2,5 mm, f = 0,315 mm/U.

Die Standzeiten, die mit der erfindungsgemäßen Schichtzusammensetzung, bei der eine zweiphasige Zwischenlage TiCN/HfO₂ eingefügt war, lag bei 12,5 min, wohingegen die mit einem Schneideinsatz mit einer nach dem Stand der Technik bekannten Beschichtung erreichbaren Standzeiten bei 10,2 min lag.

Die vorstehend erörterten Versuchsergebnisse zeigen in anschaulicher Weise, dass sowohl beim Drehen im trockenen als auch beim Drehen im nassen Schnitt erhebliche Standzeitverbesserungen erreicht werden können.

## Patentansprüche

1. Werkzeug, insbesondere Schneidwerkzeug, bestehend aus einem Substratkörper, auf dem mindestens eine zweiphasige Schicht mittels CVD abgeschieden ist,
**dadurch gekennzeichnet,**
**dass** die einzige abgeschiedene zweiphasige Schicht oder mindestens eine der zweiphasigen Schichten neben einer TiCN- oder einer TiOCN- oder TiOC- oder einer TiC-Phase eine weitere Phase, bestehend aus ZrO₂ oder HfO₂ aufweist.

2. Werkzeug nach Anspruch 1, **dadurch gekennzeichnet, dass** die weitere Phase in monokliner und/oder tetragonaler Form vorliegt

3. Werkzeug nach Anspruch 1 oder 2, **dadurch gekennzeichnet, dass** auf der Schicht, die als weitere Phase ZrO₂ oder HfO₂ enthält, Al₂O₃, vorzugsweise als äußere Schicht und weiterhin vorzugsweise als α-Al₂O₃ abgeschieden ist.

4. Werkzeug nach einem der.Ansprüche 1 bis 3, **dadurch gekennzeichnet, dass** der Substratkörper aus einem Hartmetall, einem Cermet oder einer Keramik besteht.

5. Werkzeug nach einem der Ansprüche 1 bis 4, **dadurch gekennzeichnet, dass** das Verhältnis der TiCN-, TiOCN-, TiC- oder TiOC-Phase zur weiteren Phase zwischen 4 : 1 und 1 : 4, vorzugsweise zwischen 2 : 1 und 1 : 2 liegt

6. Werkzeug nach einem der Ansprüche 1 bis 5, **dadurch gekennzeichnet, dass** in der TiCN- oder TiOCN- oder TiOC- oder TiC-Phase das Titan zu einem geringeren Anteil durch Zr und/oder Hf ersetzt ist.

7. Werkzeug nach einem der Ansprüche 1 bis 6, **dadurch gekennzeichnet, dass** die zweiphasige Schicht eine Zwischenlage zwischen zwei TiN-Schichten ist.

8. Verfahren zur CVD-Abscheidung einer zweiphasigen Schicht auf einem Substratkörper nach einem der Ansprüche 1 bis 7, **dadurch gekennzeichnet, dass** in der Gasatmosphäre neben TiCl₄, HfCl₄ oder ZrCl₄ und CO₂ zusätzlich CH₃CN (Acetonitril) oder C₅H₅N (Pyridin) oder C₆H₆ (Benzen), Rest H₂ und/oder Ar verwendet werden.

9. Verfahren nach Anspruch 8, **gekennzeichnet durch** folgende Gasanteile: TiCl₄ : 1 bis 4 Vol%, vorzugsweise 1 bis 2 Vol% ZrCl₄ oder HfCl₄ : 0,3 bis 4 Vol%, vorzugsweise 0,5 bis 2 Vol% C₅H₅N oder CH₃CN oder C₆H₆ : 0,2 bis 2 Vol%, vorzugsweise 0,5 bis 1 Vol% CO₂ : 0,1 bis 3 Vol%, vorzugsweise 0,3 bis 2 Vol%, Rest Ar und/oder H₂.

10. Verfahren nach Anspruch 8 oder 9, **dadurch gekennzeichnet, dass** die Abscheidetemperatur zwischen 800 °C und 1000 °C und der Gasatmosphärendruck zwischen 5 x 10³ und 6 x 10⁴ Pa liegt.

## Claims

1. Tool, in particular cutting tool, consisting of a substrate body, on which at least one two-phase layer is deposited by means of CVD,
**characterized**
**in that** the single deposited two-phase layer or at least one of the two-phase layers comprises, in addition to a TiCN phase or a TiOCN phase or a TiOC phase or a TiC phase, a further phase consisting of ZrO₂ or HfO₂.

2. Tool according to Claim 1, **characterized in that** the further phase is present in monoclinic and/or tetragonal form.

3. Tool according to Claim 1 or 2, **characterized in that** Al₂O₃ is deposited, preferably as an outer layer and furthermore preferably as α-Al₂O₃, on the layer containing ZrO₂ or HfO₂ as the further phase.

4. Tool according to one of Claims 1 to 3, **characterized in that** the substrate body consists of a hard metal, a cermet or a ceramic.

5. Tool according to one of Claims 1 to 4, **characterized in that** the ratio of the TiCN phase, TiOCN phase, TiC phase or TiOC phase to the further phase lies between 4:1 and 1:4, preferably between 2:1 and 1:2.

6. Tool according to one of Claims 1 to 5, **characterized in that** the titanium is replaced to a smaller proportion by Zr and/or Hf in the TiCN phase or TiOCN phase or TiOC phase or TiC phase.

7. Tool according to one of Claims 1 to 6, **characterized in that** the two-phase layer is an intermediate layer between two TiN layers.

8. Method for the CVD deposition of a two-phase layer on a substrate body according to one of Claims 1 to 7, **characterized in that** CH₃CN (acetonitrile) or C₅H₅N (pyridine) or C₆H₆ (benzene), remainder H₂ and/or Ar, are additionally used in the gas atmosphere in addition to TiC1₄, HfCl₄ or ZrCl₄ and CO₂.

9. Method according to Claim 8, **characterized by** the following gas proportions:
TiCl₄: 1 to 4% by volume, preferably 1 to 2% by volume, ZrCl₄ or HfCl₄: 0.3 to 4% by volume, preferably 0.5 to 2% by volume, C₅H₅N or CH₃CN or C₆H₆: 0.2 to 2% by volume, preferably 0.5 to 1% by volume, CO₂: 0.1 to 3% by volume, preferably 0.3 to 2% by volume, remainder Ar and/or H₂.

10. Method according to Claim 8 or 9, **characterized in that** the deposition temperature lies between 800°C and 1000°C and the gas atmosphere pressure lies between 5 x 10³ and 6 x 10⁴ Pa.

## Revendications

1. Outil, en particulier outil de coupe, constitué d'un corps de substrat sur lequel au moins une couche biphasique est déposée par CVD,
**caractérisé en ce que**
l'unique couche biphasique déposée ou au moins une des couches biphasiques déposées présente en plus d'une phase constituée de TiCN, de TiOCN, de TiOC ou de TiC une autre phase constituée de ZrO₂ ou de HfO₂.

2. Outil selon la revendication 1, **caractérisé en ce que** l'autre phase présente une forme monocline et/ou tétragonale.

3. Outil selon les revendications 1 ou 2, **caractérisé en ce que** de l'Al₂O₃ est déposé de préférence comme couche extérieure et en outre de préférence sous la forme de Al₂O₃ α sur la couche qui contient comme autre phase du ZrO₂ ou de l'HfO₂.

4. Outil selon l'une des revendications 1 à 3, **caractérisé en ce que** le corps de substrat est constitué d'un métal dur, d'un cermet ou d'une céramique.

5. Outil selon l'une des revendications 1 à 4, **caractérisé en ce que** le rapport entre la phase de TiCN, de TiOCN, de TiC ou de TiOC et l'autre phase est compris entre 4:1 et 1:4 et de préférence entre 2:1 et 1:2.

6. Outil selon l'une des revendications 1 à 5, **caractérisé en ce que** le titane est remplacé pour une plus petite fraction par Zr et/ou Hf dans la phase de TiCN, de TiOCN, de TiOC ou de TiC.

7. Outil selon l'une des revendications 1 à 6, **caractérisé en ce que** la couche biphasique est une couche intermédiaire entre deux couches de TiN.

8. Procédé de dépôt par CVD d'une couche biphasique sur un corps de substrat, selon l'une des revendications 1 à 7, **caractérisé en ce qu'**en plus de TiCl₄, de HfCl₄ ou de ZrCl₄ et de CO₂, on utilise de plus dans l'atmosphère gazeuse du CH₃CN (acétonitrile), du C₅H₅N (pyridine) ou du C₆H₆ (benzène), le reste étant H₂ et/ou Ar.

9. Procédé selon la revendication 8, **caractérisé par** les proportions gazeuses suivantes : TiCl₄ : 1 à 4 % en volume, de préférence 1 à 2 % en volume, ZrCl₄ ou HfCl₄ : 0,3 à 4 % en volume et de préférence de 0,5 à 2 % en volume, C₅H₅N ou CH₃CN ou C₆H₆ : 0,2 à 2 % en volume et de préférence de 0,5 à 1 % en volume, CO₂ : 0,1 à 3 % en volume et de préférence 0,3 à 2 % en volume, le reste étant Ar et /ou H₂.

10. Procédé selon les revendications 8 ou 9, **caractérisé en ce que** la température de dépôt est située entre 800°C et 1 000°C et la pression de l'atmosphère gazeuse entre 5 x 10³ et 6 x 10⁴ Pa.
